# EUROPEAN PATENT APPLICATION

(11) **EP 1 480 347 A1**
(43) Date of publication of application: **24.11.2004**
(21) Application number: 04018624.9
(22) Date of filing: 08.01.2001
(51) Int. Cl.: H03M 13/29

(54) **Digital transmission method of the error-correcting coding type**

(30) Priority: 21.01.2000 FR 0000875
(62) Divisional of application: 01100446.2
(71) Applicant: MITSUBISHI DENKI KABUSHIKI KAISHA, Tokyo 100-8310 (JP)
(72) Inventor: Gueguen, Arnaud, CS 10806 35708 Rennes Cedex (FR)
(74) Representative: Pfenning, Meinig & Partner

(57) **Abstract**

A digital transmission method of the error-correcting coding type comprises a coding procedure before transmission and a decoding procedure for obtaining a correction of transmission errors. The said coding procedure comprises a plurality of elementary coding steps associated in parallel or in series. The decoding procedure is iterative and comprises, for each iteration, a plurality of elementary decoding steps (51, 52, 53) which correspond to the said plurality of elementary coding steps and which each generate at least one weighted output information item which can be transmitted to one or more other elementary decoding steps. According to the invention, a characteristic quantity determination step (54) calculates at least one characteristic quantity from a set of weighted output information items generated by at least one elementary decoding step (51, 52, 53 ; 83), and a decoded information quality parameter determination step (55 ; 85) determines, from the said at least one characteristic quantity and at least one configuration parameter, a decoded information quality parameter associated with a set of decoded information items corresponding to the said set of weighted output information items. The said decoded information quality parameter can be used downstream of the said decoding procedure or even within this decoding procedure.

## Description

The present invention concerns generally a digital transmission method of the error-correcting coding type, notably for a digital transmission system on a channel with significant perturbation. More precisely, it concerns an improvement of a digital transmission method of the error-correcting coding type using turbo-code type coding schemes, allowing an estimate of decoded information quality.

A digital transmission system conveys information using a physical medium such as cable, optical fibre or propagation over a radio channel. Such a physical medium will be designated by the term channel. Generally, such a system comprises notably, at the sending level, a channel coding device for combating the imperfections of the channel and, at a destination level, a decoding device.

The channel coding device is an error-correcting coding. The error-correcting coding function consists of generating redundant information on sending, which, upon decoding at the destination, will make it possible to reconstitute the transmitted useful information from the information arriving at its destination, referred to as the received information, marred by the perturbations occurring on the channel, notably of noise, attenuation and interference type. A digital transmission method using such channel coding associated with corresponding destination decoding is referred to as an error-correcting coding type transmission method.

For example, the coding operation is carried out at bit level. This operation associates, with a binary source information sequence, a corresponding binary coded information sequence. This binary coded information sequence is referred to as a code word when the size of the binary source information sequences is fixed. The binary coded information sequence is greater in size than the binary source information sequence so as to introduce redundancy. On account of this redundancy, only certain coded information sequences, conforming to the coding law, are possible. If received information sequences to be decoded are different from these possible sequences, thi s is because they correspond to information impaired by the channel. The task of the decoding method will therefore be to reconstitute, as well as possible (the limiting factor being in general the complexity of the decoder), the transmitted useful information from the received information sequence, knowing the coding law used. Ideally, in the case of an optimal decoding in the maximum likelihood sense, the sequence supplied by the decoder is the most likely sequence amongst all the possible sequences.

The greater the capability of discriminating between the sequences allowed by the set of coding and decoding operations, the greater the error correction capability.

The performance of an error-correcting coding transmission is generally measured in terms of bit or packet error rate for a given signal to noise ratio E_{b}/Nₒ, where E_{b} is the energy per information bit and Nₒ is the power spectral density of the noise. A code is described as more or less effective according to whether its use allows a lower or less low error rate for a given E_{b}/Nₒ ratio and for a given decoding complexity.

The efficiency of the code is the number of useful information bits over the number of coded information bits. In general, the lower the efficiency, the more robust the code.

Some known error-correcting codes are the block codes. Block coding consists of associating, with each block of k information bits, a block of n bits (n>k) therefore containing (n-k) redundant bits. The block of n bits is obtained by multiplying the block of k source bits by a matrix with k rows and n columns referred to as a generator matrix of the code. When, by permutation, the generator matrix is written in a form such that it reveals the identity matrix, so that, in the block of n bits, the k information bits and the n-k redundant bits are separate, the code is referred to as systematic. The efficiency of the code is equal to k/n. The decoding device detects the errors and corrects them. Such error detecting codes well known in the art are for example Hamming codes, BCH codes and Reed-Solomon codes.

The fact is also well known of performing an error-correcting coding by means of one or more convolutional coders. Their principle of operation consists of coding a block of k binary elements present at the input of the coder into a block of n binary elements, also taking into account m blocks preceding the block present at the input, by means of a device with a register of shift register type. The output of the convolutional coder is composed of n coded binary elements generated by the product of convolution of the k binary elements present at the input with the response of the coder defined by n generator polynomials. The number n of generator polynomials of the coder is referred to as the dimension of the coder. The efficiency of the code is equal to k/n. The decoding device reconstructs the original data for example by means of a sequential type decoding, a decoding according to the most likely symbol, or a decoding according to the most likely sequence, as described, for example, in the document "Digital Communications", by J.G. Proakis, published in 1995 by MacGraw-Hill. For example, the Viterbi algorithm provides an optimal decoding according to the most likely sequence.

According to a variant of this type of code, the coding is not performed by directly taking into account a series of m source information items preceding the information to be coded, but by using a series of m auxiliary information items, stored in a device of shift register type and each obtained by mathematical combination of a useful information item available at the input and m auxiliary information items calculated previously. Such a convolutional code is referred to as recursive. When, furthermore, the useful information appears as it stands amongst the n outputs of the coder, the resulting code is referred to as recursive systematic, denoted RSC (for Recursive Systematic Convolutional code).

The fact is also known of associating different coders in order to increase the performance of the coding. For example, the data coded by a first coder can feed a second coder. The decoding is performed symmetrically, starting with the second code.

One effective type of coder association has been proposed, as described notably in the document "Near Shannon Limit Error-Correcting Coding and Decoding: Turbo-codes", by C. Berrou, A. Glavieux, P. Thitimajshima, published in ICC-1993, Conference Proceedings on pages 1064-1070. This type of coder association has given rise to a family of coding schemes known in the art by the name turbo-codes. Turbo-codes will designate the error-correcting codes based on the association, referred to as concatenation, of a number of simple codes, referred to as elementary codes, with the intervention of permutation operations, referred to as interleavings, which modify the order in which the data are taken into account by each of the simple codes. For example, the interleaving can be obtained, in a conventional manner, by means of an interleaving matrix in which the data are inserted row by row and restored column by column. Such an interleaving is referred to as uniform interleaving. However, for performance reasons, turbo-codes use in general non-uniform interleavings. Elementary codes means codes of efficiency greater than or equal to 1, of the type described above. These may be, for example, recursive systematic convolutional codes for the convolutional turbo-codes, Hamming or BCH block codes for the block turbo-codes. Different types of concatenation can be envisaged. In parallel concatenation, the same information is coded by each coder separately after having been interleaved. In serial concatenation, the output of each coder is coded by the following coder after having been interleaved. The number of elementary coders used to implement this turbo-code is referred to as the dimension of the turbo-code. One well-known turbo-coding scheme consists of a parallel concatenation of convolutional code type elementary codes. This turbo-code is designated by the term PCCC. Examples of serial concatenation turbo-codes are the SCCCs which use convolutional code type elementary codes and the block turbo-codes which use block code type elementary codes.

Information coded by a turbo-code can be decoded by an iterative method referred to as turbo-decoding. An example of turbo-decoding is given in the aforementioned document "Near Shannon Limit Error-Correcting Coding and Decoding: Turbo-codes", by C. Berrou, A. Glavieux, P. Thitimajshima, published in ICC-1993, Conference Proceedings on pages 1064-1070. This example concerns the turbo-decoding of a parallel concatenation turbo-code. There are associated a number of elementary decoders with weighted inputs and outputs each corresponding to an elementary coder of the coding device. The weighted inputs and outputs are effected in terms of probabilities, likelihood ratios, or log likelihood ratios generally denoted LLR. The weighted inputs and outputs are in general associated with each of the Mary symbols at the input and output of the elementary coders, that is to say, for example, with bits if binary coders are used as elementary coders. The decoders act one after another in the case of serial turbo-decoding or simultaneously in the case of parallel turbo-decoding. Intermediate concatenation schemes can also be envisaged. Interleavers and de-interleavers allow each decoder to take into account an information item which appears in the same form as the one at the output (and also at the input in the case of parallel decoding) of the corresponding coder. Each elementary decoder uses only part of all the information available at the input of the turbo-decoder, namely an impaired version of the information at the output (and also of the information at the input in the case of parallel decoding) of the corresponding elementary coder. This information, referred to as a priori information, is composed, on the one hand, of the information present at the output of the step preceding the channel decoding, namely in general the demodulator, and, on the other hand, of the information generated by one or more previous elementary decoders. By virtue of this a priori information and knowing the coding law of the corresponding elementary coder, the elementary decoder generates a posteriori information which is an estimate of greater reliability of the information at the input. The additional information compared with the information at the input of the elementary decoder is referred to as extrinsic information. This extrinsic information is transmitted to the following elementary decoder after interleaving or de-interleaving. Each decoder therefore has at the input a priori information, the quality of which is increased by the work of previous elementary decoders. This extrinsic information depends on the redundant information introduced by the corresponding coder. The method is iterative in that the extrinsic information calculated by the last decoder or decoders of the series is propagated back to the first decoder or decoders of the series. The exchange of extrinsic information is performed between elementary decoders within one and the same step, and from this step to the following step. Each new step therefore increases the reliability of the information generated at the output. After a certain number of iterations the method will converge. A thresholding is applied in order to generate the decoded information.

Of course, the name turbo-decoding includes various conceivable concatenation schemes, depending for example on the type of turbo-coding implemented. For example, in the turbo-decoding corresponding to a serial concatenation turbo-code, the elementary decoders being associated in the opposite order to the elementary coders, each elementary decoder receives two a priori weighted information items, one corresponding to the output information of the corresponding elementary coder, and the other to the input information of the corresponding elementary coder. This elementary decoder produces two a posteriori weighted information items, one corresponding to the output of the corresponding elementary coder, and which therefore becomes, during a following iteration, after corresponding interleaving, the a priori input of a previous elementary decoder, and the other corresponding to the input of the corresponding elementary coder, and which therefore becomes, in the same iteration, after corresponding de-interleaving, the a priori input of a following elementary decoder.

Be that as it may, extrinsic information can always be defined as the additional information provided by an elementary decoding associated with an elementary coding with respect to an a priori information item, occurring at the input of the elementary decoding.

Furthermore, various types of algorithm can be used for elementary decoders with weighted inputs and outputs. The elementary decoders use for example the MAP, LogMAP and MaxLogMAP, also referred to as APP, LogAPP and MaxLogAPP, algorithms, which all derive from the calculation of a posteriori probabilities knowing a priori probabilities. Reference can be made, for a description of such decoding algorithms, for example to the article "Optimal and sub-optimal maximum a posteriori algorithms suitable for turbo decoding" by P. Robertson, P. Hoeher, E. Villebrun, published in European Trans. on Telecommun., vol. 8, March-April 1997, on pages 119-125. Algorithms of the modified Viterbi algorithm type can also be used for associating, with each decision, a reliability measurement of a type comparable to the LLR (log likelihood ratio). The SOVA algorithm (Soft Output Viterbi Algorithm) can for example be used. For block turbo-codes, use can be made of a Chase algorithm, as described in the article "A very low complexity block turbo decoder for product codes" by R. Pyndiah, P. Combelles and P. Adde, published in IEEE Globecom of 1996, on pages 101 to 105.

The fact is also known that the efficiency of a code can be increased by a puncturing operation which consists of not transmitting certain bits of an information sequence, as described, for example, in the article "Rate-Compatible Punctured Convolutional (RCPC) codes and their application", by J. Hagenauer, published in IEEE Trans., Vol COM-36.4, 1988, on pages 389-400 or in the article "New Rate Compatible Punctured Convolutional Codes for Viterbi decoding", by L.H.C. Lee, published in IEEE Trans., Vol. COM-42.2, 1994, on pages 3073-3079. These non-transmitted bits are in general redundant information bits. This puncturing operation occurs at sending level, after the coding operation. At destination level, a reciprocal de-puncturing operation is performed before the decoding operation. The puncturing operation is defined by a puncturing scheme or matrix, the de-puncturing operation being defined by a corresponding de-puncturing scheme or matrix. The puncturing of redundant information bits decreases the correction capability of the code and increases its efficiency.

The error-correcting codes of the turbo-code family according to the state of the art described above make it possible to obtain a very effective error correction while retaining sufficiently large efficiencies and allowing decoding operations of low complexity compared with the complexity of the code. In its principle, the turbo-decoding is sub-optimal. However, it gives rise to performances close to those of the optimal decoder, its complexity being clearly lower since it is of the order of that of the decoding of the elementary codes.

It is known that the performance of an error-correcting code varies according to the transmission conditions. Transmission conditions means the parameters influencing the performance of the transmission such as notably the signal to noise ratio. As for the performance, this is evaluated notably by means of the bit or packet error rate. Furthermore, many applications require the establishment of a compromise between, on the one hand, the performance and, on the other hand, parameters of use such as the complexity of the system or the decoding time as described for example by: Bonghoe K. et al, "Reduction of the number of iterations in turbo decoding using extrinsic information" disclose an algorithm for a turbo decoder which estimates whether the decoded data are erroneous or not, based on a set of extrinsic information from a present decoding step and on a previous decoding step. The algorithm also incorporates a configuration parameter which adapts the algorithm to varying system characteristics such as interleaver size. The algorithm estimating whether the decoded data are erroneous or not, is based on a comparison. The comparison provides a true/false decision which indicates whether the decoded data are correct or not. This is the prior art in stop criterion.
Schurgers C. et al., "Adaptive turbo decoding for indoor wireless" disclose an algorithm for a turbo decoder which estimates whether the decoded data are erroneous or not, based on a statistical quality of a set of extrinsic information from a present decoding step. The algorithm also incorporates a configuration parameter which adapts the algorithm to varying system characteristics such as the signal to noise ratio. The algorithm estimating whether the decoded data are erroneous or not, is based on a comparison. The comparison provides a true/false decision which indicates whether the decoded data are correct or not. This is the prior art in stop criterion.
FR 2730370 discloses a joint detection and convolution decoder. The convolutional decoder could be a turbo decoder. The convolution decoder outputs extrinsic information. This is the prior art in turbo equalization. In many cases, the decoding does not lead to a correction of all the transmission errors. The possibility of having access to parameters characterising the quality of the decoded information can then prove advantageous.

The turbo-decoding being composed of a succession of decoding operations carried out in a loop, based each time on different redundant information, it is difficult to evaluate simply the quality of the decoded information. This poses a number of problems.

For example, it is difficult to fix a priori the number of iterations the decoding method has to perform. In general, therefore, a maximum number of iterations is fixed corresponding to a tolerated complexity and/or maximum decoding time, and a stopping criterion is used to interrupt the decoding process if the latter seems to have converged to the transmitted sequence before the maximum number of iterations. The detection of convergence can be performed in different ways. For example a CRC (Cyclic Redundancy Check) type error-detecting code can be used: if, during the turbo-decoding of a block, calculation of the error-detecting code indicates that there are no more errors, the iterative decoding of the said block is interrupted. One drawback of this first method is that the said error-detecting code must be introduced on sending, causing notably a drop in the overall efficiency of the channel coder. Another way consists of detecting a stagnation of the outputs of the elementary decoders during the iterative decoding of a sequence. Such a stagnation effectively indicates that additional decoding iterations will not further reduce the number of errors in the sequence under consideration. Although this way of proceeding makes it possible relatively simply to control the stopping of the decoding processing, it gives no information on the quality of the decoded sequences, that is to say on the number of errors they still contain compared with the information sent.

For many applications, it would be desirable to be able to know the number of errors remaining in a block of decoded information. More generally, it could be advantageous to know the quality of the decoded information at the output of each elementary decoder and for each iteration.

Within the context of the present invention, a parameter which is simple to access, and making it possible to evaluate the quality of a decoded sequence, has been sought.

A study undertaken in this direction, taking the example of a PCCC type turbo-code with turbo-decoding of an N-bit sequence by a LogMAP type algorithm, revealed that there exists a correlation between, on the one hand, the mean of the absolute value of the extrinsic information calculated on the sequence of N extrinsic values at the output of a given decoder during a given iteration and, on the other hand, the number of errors remaining in the decoded N-bit sequence at the output of this given decoder for this given iteration. The higher this mean, the more probable it is that the number of errors remaining in the sequence is small.

It has been possible to draw up a reference table giving the correspondence between this mean and the mean number of bit errors per sequence for different transmission conditions characterised by the signal to noise ratio.

It has also been possible to draw up similar reference tables from other quantities representing the extrinsic information for a given number of information items at the output of an elementary decoding operation, such as the minimum, the maximum or the moments of order greater than 1.

It has been shown, more generally, for all types of turbo-code, with parallel or serial concatenation, that it was always possible to calculate, from a certain number of weighted information items at the output of one or more elementary decoding operations, a quantity characteristic of the quality of a set of information items, at the output of the last elementary decoding operation considered, corresponding to the said set of weighted information items.

An object of the present invention is therefore to propose a transmission method of the type with error-correcting coding by means of turbo-codes by which there is available a parameter characteristic of a decoded information quality at any decoding step, during any decoding iteration.

The invention is defined according to the appended claims.

To that end, it proposes a digital transmission method of the error-correcting coding type, comprising, before a step of transmitting on a channel, a coding procedure for generating, from a useful information item, a coded information item comprising at least one redundant information item and, after the said step of transmitting on the said channel, a decoding procedure for obtaining, from a received information item to be decoded, an estimate of the said source information item with correction of transmission errors based on the said at least one redundant information item, the said coding procedure comprising a plurality of elementary coding steps associated with a plurality of interleaving steps and acting in parallel or in series, the said decoding procedure being iterative and comprising, for each iteration, a plurality of elementary decoding steps which corresponds to the said plurality of elementary coding steps with association with a plurality of adapted interleaving and de-interleaving steps, each of the said elementary decoding steps generating at least one weighted output information item which can be transmitted to one or more other elementary decoding steps, the said method being characterised in that it comprises a characteristic quantity determination step for calculating at least one characteristic quantity from a set of weighted output information items generated by at least one elementary decoding step, and a decoded information quality parameter determination step for determining, from the said at least one characteristic quantity and at least one configuration parameter, a decoded information quality parameter associated with a set of decoded information items corresponding to the said set of weighted output information items.

Thus defined, the present invention applies to all types of transmission method using an error-correcting coding of turbo-coding type, whether this is a serial or parallel turbo-coding.

It also applies within the context of turbo-equalization, where the channel is considered as a convolutional coder, or within the context of turbo-detection.

The decoded information quality parameter can be used after the turbo-decoding or even within the turbo-decoding process.

According to another aspect of the present invention, each of the said elementary decoding steps uses part of the said received information, which corresponds to an information item containing redundant information associated with the corresponding elementary coding step, for generating an output information item comprising an extrinsic information item which can be transmitted to another elementary decoding step, at least one extrinsic information item obtained during one iteration being transmitted to another iteration, and the said characteristic quantity determination step calculating the said at least one characteristic quantity during an elementary decoding step from a set of extrinsic information items at the output of the said elementary decoding step.

Advantageously, the characteristic quantity is a statistical quantity. It can be the mean of the absolute value of the extrinsic information calculated on the said set of extrinsic information items. It can also be other statistical quantities such as the variance, the minimum or the maximum.

According to another aspect of the present invention, the said quality parameter determination step determines the said decoded information quality parameter from a characteristic quantity calculated during an elementary decoding step from a set of weighted output information items of the said elementary decoding step and other characteristic quantities calculated during previous elementary decoding steps from sets of weighted output information items corresponding to the said set of weighted output information items of the said elementary decoding step, and at least one configuration parameter, the said decoded information quality parameter being associated with a set of decoded information items corresponding to the said set of weighted output information items of the said elementary decoding step.

Advantageously, the said quality parameter determination step determines the said quality parameter from characteristic quantities calculated during elementary decoding steps corresponding to the last elementary decoding steps of the said decoding procedure.

However, the said quality determination step can also determine the said quality parameter from a single characteristic quantity calculated during the last elementary decoding step of the said decoding procedure.

For certain applications, the said output information quality parameter is an integer number representing the probable number of errors in the block under consideration.

For other applications, the said output information quality parameter is a scalar used as a weighting factor.

In this case, the larger it is, the more reliable the output information.

A configuration parameter can be a parameter characterising the transmission conditions, for example the signal to noise ratio.

The said information quality parameter determination step can use a predetermined algorithm allowing calculation of the information quality parameter as a function of one of more characteristic quantities and configuration parameters.

This information quality parameter determination step can also use predetermined reference tables making it possible to select an information quality parameter as a function of one of more characteristic quantities and configuration parameters.

According to another aspect of the present invention, the received information being processed by means of N-bit decoding sequences, the said set of decoded information items is a sequence of binary information items containing N bits.

This embodiment of the present invention is particularly advantageous for applications consisting of assigning a decoded information quality parameter to a decoded sequence at the output of the decoding procedure.

Alternatively, the received information being processed by means of N-bit decoding sequences, the said set of decoded information items is a sequence of binary information items which represents only a fraction of an N-bit decoding sequence.

This embodiment of the present invention is advantageous for applications consisting of using a decoded information quality parameter in the turbo-decoding process itself, by converting it into a weighting factor for the set of extrinsic information items corresponding to the decoding sequence fraction, in order to favour to a greater or less extent certain sets of extrinsic information items and improve the convergence of the turbo-decoding method.

According to another aspect of the present invention, the said elementary decoding steps have inputs and outputs which are weighted, in terms of probabilities, likelihood ratios, or log likelihood ratios.

According to another aspect of the present invention, the said coding procedure comprises at least one puncturing step and the said decoding procedure comprises at least one corresponding de-puncturing step.

According to another aspect of the present invention, in a combination of transmission methods using a number of decoding procedures associated with one and the same coding procedure, the decoded information quality parameters obtained for each of the decoding procedures can be used as weighting factors for the sets of decoded information items with a view to a combination of these sets.

According to another aspect of the present invention, in a transmission method comprising, furthermore, a joint detection step, the said decoded information quality parameter can be used as a parameter of the said joint detection step.

The characteristics of the invention mentioned above, as well as others, will emerge more clearly from a reading of the following description of an example embodiment, the said description being given in relation to the accompanying drawings, amongst which:
Figure 1 is a diagram illustrating a two-dimensional PCCC type turbo-code coding device;
Figure 2 is a diagram illustrating a serial mode decoding device associated with the coding device of Figure 1;
Figure 3 is a graph showing the distribution of the mean of the absolute value of the extrinsic information as a function of the mean number of errors per decoded sequence, for a given decoding step and for different transmission conditions;
Figure 4 is a flow diagram illustrating a basic principle of a decoding procedure with determination of a decoded information quality parameter according to one embodiment of the present invention;
Figure 5 is a flow diagram illustrating a basic principle of a decoding procedure with determination of a decoded information quality parameter according to another embodiment of the present invention;
Figure 6 is a flow diagram illustrating the application of the present invention to a transmission method comprising a plurality of decoding procedures whose outputs are combined; and
Figure 7 is a flow diagram illustrating the application of the present invention to a transmission method comprising a joint detection step.

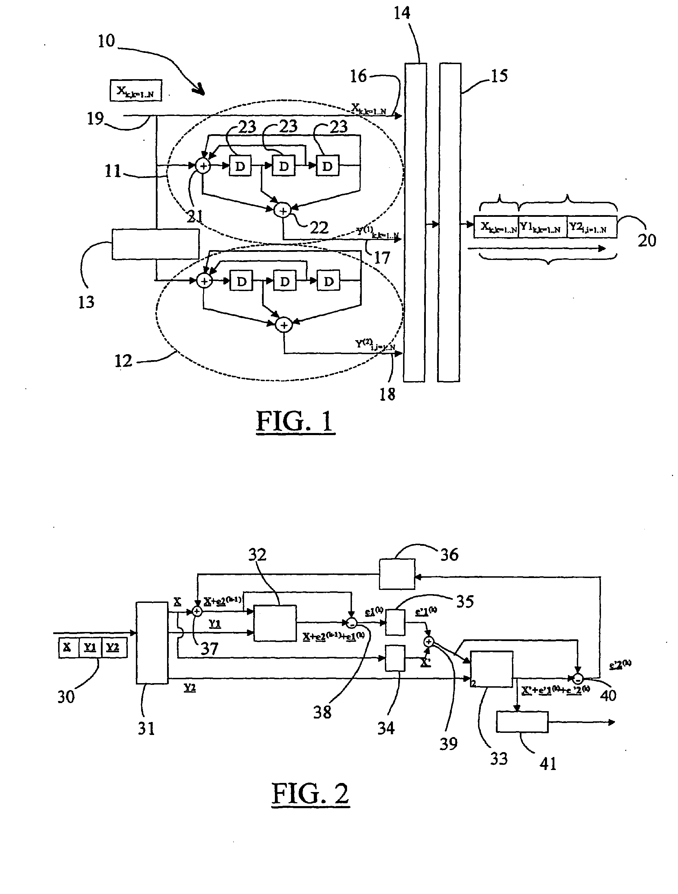

The present invention will be illustrated notably with reference to a transmission method of the type with error-correcting coding using a two-dimensional PCCC type turbo-code, a turbo-coding device applying this method being depicted schematically in Figure 1, and a turbo-decoding device applying this method being depicted in Figure 2. The invention can easily be generalized to turbo-codes of greater dimension, using other types of elementary codes, and/or with different concatenation schemes, notably serial concatenation schemes.

In the main, a digital transmission method of the type with error-correcting coding by means of PCCC turbo-codes comprises a coding procedure before a transmission step and a decoding procedure after a transmission step.

The coding procedure is illustrated through the coding device depicted schematically in Figure 1.

In the main, this coding device 10 comprises two elementary coders 11 and 12 between which there acts an interleaver 13 of size N.

Each of the elementary coders 11 and 12 is a coder using a Recursive Systematic Convolutional (RSC) code. As is well known, each of these elementary coders uses a series of auxiliary information items, stored in a shift register type device, each obtained by mathematical combination of a useful information item and auxiliary information items calculated previously. In the example presented here, the shift register 23 stores up the auxiliary data calculated by the Exclusive OR gate 21. The convolution product is implemented by the Exclusive OR gate 22, the generator polynomial being formed by the outputs of the register 23. The useful information is systematically transmitted by the side of a redundant information item which appears at the output of the Exclusive OR gate 22. The step 13 of interleaving of size N modifies the order in which the data are taken into account by each of the elementary codes. In that way, each of the coders 11 and 12 generates a redundant information item which is associated therewith. The source information is transmitted only once. Thus, the coded information as it emerges from the coding procedure is a block 20 comprising the useful information, or systematic part, and the two redundant information items, or parts of the coded information corresponding to each of the elementary codes. Of course, the two elementary codes could be different. After multiplexing 14, the coded information can be subjected to a puncturing 15. The efficiency of each of the elementary coders is ½ and, on account of the systematic part being transmitted only once, the efficiency of the turbo-code is 1/3. This efficiency can, of course, be increased by puncturing. Thus, the puncturing of half the redundant bits of each elementary code would produce an efficiency of ½.

The coded and possibly punctured information is transmitted by means of sequences 20 of length N/R where R is the efficiency of the turbo-code, including puncturing. These sequences are subject to the modifications brought about by the channel. They are next received by the decoding device, after possible de-puncturing. Weighted information sequences 30 of length N/R appear at the input of the demultiplexer 31. Each of these blocks 30 constitutes a received information item to be decoded. They contain a received information part corresponding to the useful information, referred to as systematic information X, a first received information part corresponding to the redundant information of the first elementary code, referred to as first redundant information Y1, and a second received information part corresponding to the redundant information of the second elementary code, referred to as second redundant information Y2. The decoding procedure works by means of N-bit decoding sequences corresponding to the sequences of N blocks received.

The decoding device comprises an elementary decoder 32 corresponding to the first elementary coder 11 and an elementary decoder 33 corresponding to the second elementary coder 12, concatenated in series. In the example considered here, the elementary decoders, using a LogMAP type algorithm, have inputs and outputs weighted in the form of a log likelihood ratio (LLR). For this reason, the extrinsic information is initialized to 0 and the combination of the extrinsic information with the systematic information is performed by an addition. Of course, if the quantities handled by the elementary decoders are something else, it will be necessary to make the corresponding changes. For example, if they are likelihood ratios, the extrinsic information is initialized to 1 and the combination is performed by a product. If they are probabilities, the extrinsic information is initialized to 0.5 and the combination is also performed by a product.

The received information part X corresponding to the source information is furthermore transmitted to the elementary decoders 32 and 33. In the direction of the elementary decoder 32, an adder 37 adds, to this systematic information X, an extrinsic information item e2_{k'-1}. In the direction of the elementary decoder 33, an adder 39 adds, to this systematic information X, interleaved by an interleaver 34 of size N corresponding to the interleaver 13, an extrinsic information item e1_{k'}, interleaved by an interleaver 35 of size N corresponding to the interleaver 13. Moreover, the received information part Y1 corresponding to the redundant information of the first elementary code is transmitted to the decoder 32 and the received information part Y2 corresponding to the redundant information of the second elementary code is transmitted to the decoder 33.

The index k' represents the current iteration of the decoding procedure, the extrinsic information e2_{k'-1} therefore being calculated during an iteration preceding the one during which the extrinsic information e1_{k'} is calculated.

The extrinsic information e1_{k'} is obtained at the output of the elementary decoder 32 during an iteration k', with subtraction, at a subtractor 38, of the systematic information X and the extrinsic information e2_{k'-1}.

The extrinsic information e2_{k'} is obtained, in interleaved form e'2_{k'}, at the output of the elementary decoder 33 during an iteration k', with subtraction, at a subtractor 40, of the interleaved systematic information X' and the interleaved extrinsic information e'1_{k'}. It is de-interleaved by a de-interleaver 36 of size N corresponding to the interleaver 13 before transmission to the following iteration.

At the end of a decoding procedure, that is to say after a given number k of iterations, a decoding sequence at the output of the second elementary decoder 33 is de-interleaved and analyzed by a decision block 41 to form a decoded sequence.

At the start, the extrinsic information e2₀ is initialized to 0. During the first iteration, the systematic information X forms the a priori input information of the first elementary decoder 32. The first elementary decoding, from the first redundant information Y1, produces a weighted output information item D1₁, corresponding to a first decoding sequence estimate, written in the form of a combination of the systematic information and the extrinsic information e1₁, the latter corresponding to an increase in the reliability associated with the first elementary decoding. This gives D1₁= X + e1₁, the extrinsic information e1₁ being written as the difference between the weighted output information of the first decoder, here the log likelihood ratio at the output, and the weighted input information of the first decoder, here the log likelihood ratio at the input. This extrinsic information e1₁, interleaved and added to the interleaved systematic information X', forms the a priori input information of the second elementary decoder 33. The second elementary decoding, from the second redundant information Y2, produces a weighted output information item D'2₁, which corresponds to a second decoding sequence estimate, and which is written in the form of a combination of the interleaved systematic information, the interleaved extrinsic information e'1₁ and the interleaved extrinsic information e'2₁, the latter corresponding to an increase in the reliability associated with the second elementary decoding. This gives D'2₁ = X'+e'1₁+e'2₁, the interleaved extrinsic information e'2₁ being written as the difference between the weighted output information of the second decoder, here the log likelihood ratio at the output, and the weighted input information of the second decoder, here the log likelihood ratio at the input. The interleaved extrinsic information e'2₁ forms, after de-interleaving, the extrinsic information e2₁ which, added to the systematic information X, forms the a priori input information of the first elementary decoder 32 for the second iteration. The elementary decoding, still from the first redundant information Y1, then produces a weighted output information item D1₂, which corresponds to a new decoding sequence estimate of increased reliability. A new extrinsic information item associated with the decoder 32, e1₂, interleaved and added to the interleaved systematic information X', forms the a priori input information of the second elementary decoder 33. The second elementary decoding, still from the second redundant information Y2, produces a weighted output information item D'2₂, which corresponds to a new decoding sequence estimate of increased reliability. A new extrinsic information item associated with the decoder 33, e2₂, added to the systematic information X, forms the a priori input information of the first elementary decoder 32 for the third iteration. The process then continues in the same manner, the extrinsic information gaining in reliability, that is to say in amplitude in the present case where it is expressed in terms of log likelihood ratio, as the iterations progress. At the end of a given number of iterations k, the interleaved decoding sequence composed of the weighted output information items D2ᵢ at the output of the second elementary decoder 33 is de-interleaved and thresholded to produce the decoded sequence.

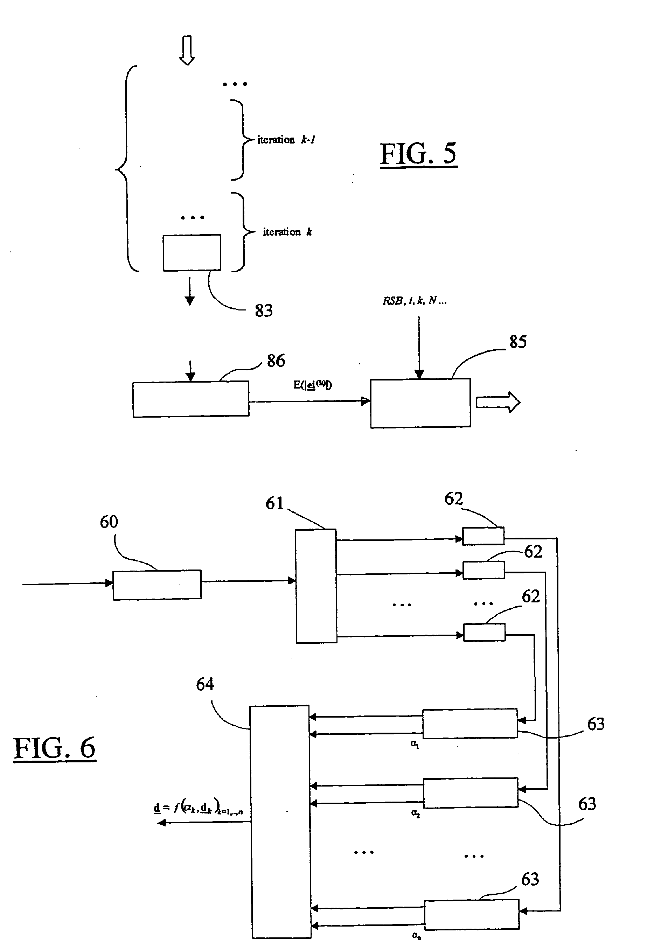

Figure 5 depicts an embodiment of the present invention applied to the case of an i-dimensional PCCC like the 2-dimensional PCCC which has just been described. According to the invention, a characteristic quantity determination step 86 executes an algorithm consisting, during the last elementary decoding step 83 of the decoding procedure, that is to say the step corresponding to the i^{th} elementary decoding of the k^{th} iteration, of calculating the mean E |eiₖ| of the absolute value of the extrinsic information calculated on the sequence of N extrinsic values at the output of the i^{th} decoder during the k^{th} iteration. In the case of the 2-dimensional PCCC described, this step 86 will calculate, during the elementary decoding performed by the second decoder 33 during the k^{th} iteration, the mean E|e2ₖ| of the absolute value of the extrinsic information calculated on the sequence of N extrinsic values at the output of the second decoder 33 during the k^{th} iteration.

A decoded information quality parameter determination step 85 receives the characteristic quantity E|eiₖ|. It also receives other parameters which are configuration parameters, that is to say parameters making it possible to characterise the system for which the decoded information quality evaluation is performed. These may be notably the estimated signal/noise ratio, the size N of the decoding sequences, the value i and the value k. They may also be parameters characterising the puncturing or any other parameter capable of modifying the quality of the decoded information.

In order to determine, at the end of the elementary decoding step 83, from the characteristic quantity E|eiₖ| and the configuration parameters, a decoded information quality parameter associated with the sequence of N decoded information items corresponding to the sequence of N extrinsic values at the output of the i^{th} elementary decoder, the determination step uses a predetermined algorithm or predetermined reference tables. This algorithm or these reference tables are predetermined according to a prior study of the distribution of the mean of the absolute value of the extrinsic information as a function of the mean number of errors per decoded sequence, for different configuration parameters.

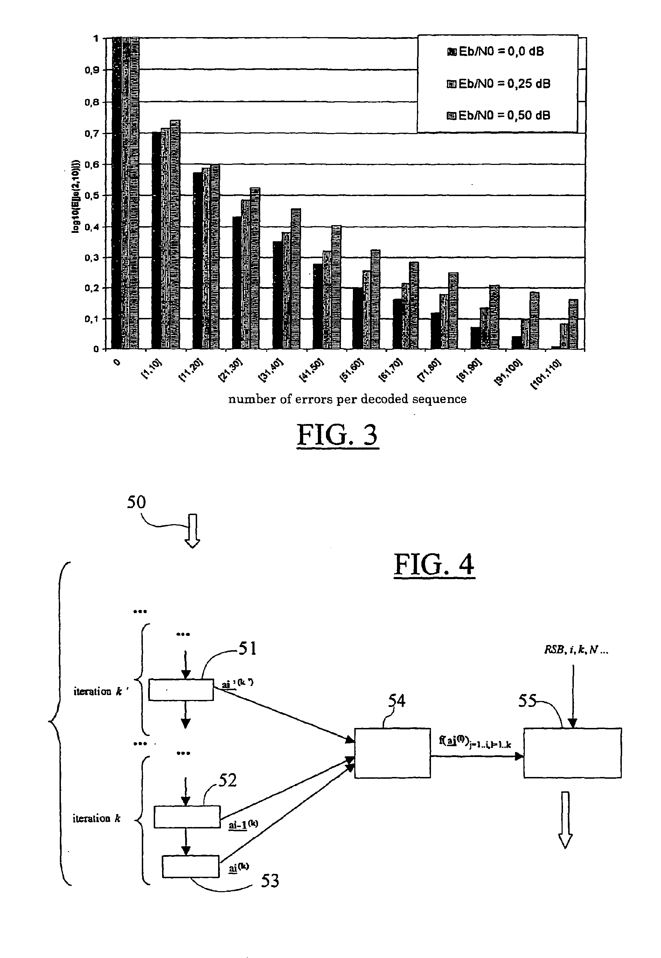

By way of example, Figure 3 shows in graph form a result of such a study for the PCCC of the present embodiment. This is the distribution of the mean E|e2₁₀| of the absolute value of the extrinsic information at the output of the 2^{nd} decoder of the 10^{th} iteration as a function of the mean number of errors per decoded sequence, the length of the sequence (corresponding to the size of the interleavers) being N=640. This distribution is drawn up for three values of signal to noise ratio: the first line corresponding to a signal to noise ratio of 0 dB, the second line corresponding to a signal to noise ratio of 0.25 dB and the third line corresponding to a signal to noise ratio of 0.5 dB. The signal at the output of the turbo-coder is modulated by a BPSK modulation and transmitted on a channel with Additive White Gaussian Noise (AWGN). Quantities E |e2₁₀| are calculated for sufficient sequences to obtain a "smooth" distribution. On the x-axis, the number of errors are shown in intervals of ten so as to have sufficient statistics per interval. The case corresponding to 0 errors is considered separately since the corresponding value of E|e2₁₀| is much higher than for the other cases. On the y-axis, the absolute value of the extrinsic information is shown in the form log (E|e2₁₀|).

The distribution graph obtained, made use of for example by means of a reference table, makes it possible, for a given signal to noise ratio, forming a configuration parameter, to deduce, from the characteristic quantity associated with a sequence of N decoded data items, a probable number of errors remaining in this sequence. This number of errors here forms the information quality parameter which according to the invention is associated with a decoded information sequence. For example, for a signal to noise ratio of 0 dB, a value of the characteristic quantity E|e2₁₀| of 2.51, whose logarithm is 0.4, indicates that there are about thirty errors remaining in the 640 decoded bits. This quality parameter can, depending on application, be of a different kind.

Of course, the information quality parameter determination step can be based on a number of characteristic quantity distributions like that depicted in Figure 3 and corresponding to various configuration parameter values.

Figure 4 is a flow diagram illustrating in a more general manner the basic principle of a decoding procedure with determination of a decoded information quality parameter according to one embodiment of the present invention.

According to the invention, a characteristic quantity determination step 54 executes an algorithm consisting, during the elementary decoding steps of the decoding procedure, like the depicted steps 51, 52 and 53 corresponding respectively to the i'^{th} elementary decoding of the iteration k', to the (i-1)^{th} elementary decoding of the iteration k and to the i^{th} elementary decoding of the iteration k, that is to say the last elementary decoding, of calculating a function f(ajₗ)_{j=1...i, l=1...k} giving characteristic quantities of a set of weighted information items aj_{l, j=1...i, l=1...k} corresponding to all or part of a decoding sequence at the output of each of these elementary decoding steps. The characteristic quantities may be statistical quantities such as amplitude means, variances, minima, maxima, etc. The function f may give characteristic quantities of a set of weighted information items at the output of the last elementary decoding steps of the decoding procedure. It may also give a characteristic quantity of a set of weighted information items at the output of the last elementary decoding step of the decoding procedure, whether this is situated at the end of or within a decoding iteration.

A decoded information quality parameter determination step 55 receives the characteristic quantities f(ajₗ)_{j=1...l, l=1...k} and configuration parameters. Here again, these may be notably the estimated signal/noise ratio, the size N of the decoding sequences, the value i and the value k, parameters characterising the puncturing or puncturings performed, parameters characterising the interleaving or interleavings used, etc.

In order to determine, at the end of the elementary decoding step 53, from the characteristic quantities f(ajₗ)_{j=1...i, l=1...k} and the configuration parameters, a decoded information quality parameter associated with the set of decoded information items corresponding to the set of weighted information items aiₖ at the output of the i^{th} elementary decoder during the k^{th} iteration, the information quality parameter determination step uses a predetermined algorithm or predetermined reference tables. This algorithm or these reference tables are predetermined according to a prior study of the distribution of the characteristic quantities as a function of a decoded information quality parameter for different configuration parameters. This quality parameter may be an integer number representing the probable number of errors in the set of decoded information items or perhaps a scalar used as a weighting factor or any other parameter needed for a given application.

In the embodiment which has just been described, the decoded information quality parameter according to the invention is notably designed for applications downstream of the turbo-decoding procedure, examples of which will be given subsequently. In this case, it is generally calculated for a set of decoded information items corresponding to an entire decoding sequence. Furthermore, it is generally calculated either during elementary decoding steps which are the last steps in the decoding procedure, or even during the last elementary decoding step in the decoding procedure. However, such a decoded information quality parameter can also be used even within the turbo-decoding process. A set of decoded information items, with which a decoded information quality parameter is associated, means any set of decoded information items at the end of an elementary decoding step which is not necessarily the last step in the decoding procedure. For example, such a decoded information quality parameter can be calculated at the end of an elementary decoding step in order to modify a subsequent elementary decoding step. In this case, it can also be calculated for a set of decoded information items corresponding to a decoding sequence fraction, in order, for example, to give different weights to a certain number of subsets of a decoding sequence, in order to favour, during subsequent steps, this or that subset according to the quality of the information it contains.

The present invention applies to all types of transmission method using an error-correcting coding of turbo-coding type, whether it is a serial or parallel turbo-coding, or perhaps even a turbo-code with a hybrid concatenation scheme mixing serial concatenation and parallel concatenation.

An embodiment of the present invention applied to a serial turbo-code will be described briefly.

For example, in a serial concatenation turbo-code, each elementary coder generates an elementary coded information item from the elementary coded information item issuing from the previous elementary coder, the i elementary coders being separated by (i-1) interleavers. Puncturing steps may be distributed in the coding procedure, the output of a j^{th} coder possibly being punctured by a j^{th} puncturing vector, interleaved by a j^{th} interleaver before coding by a (j+1)^{th} coder. The size of each interleaver depends on the previous coding step, and, in particular, the efficiency after puncturing of the previous elementary coder.

In an example of turbo-decoding corresponding to the serial concatenation turbo-coding which has just been described, the elementary decoders being associated in the opposite order to the elementary coders, each elementary decoding step receives two a priori weighted information items, one, referred to as the first input information, corresponding to the output information of the corresponding elementary coder, and the other, referred to as the second input information, corresponding to the input information of the. corresponding elementary coder. This elementary decoding step produces two a posteriori weighted information items, one, referred to as the first output information, corresponding to the output of the corresponding elementary coder, and which therefore becomes, during a following iteration, after interleaving and corresponding puncturing, the a priori input of a previous elementary decoder, and the other, referred to as the second output information, corresponding to the input of the corresponding elementary coder, and which therefore becomes, in the same iteration, after de-interleaving and corresponding de-puncturing, the a priori input of a following elementary decoder. The first input information corresponds to the information to be decoded by the elementary decoding step. The second output information corresponds to the information decoded by the elementary decoding step, and is composed of the combination of the second input information and an extrinsic information item.

According to the present invention, the characteristic quantity determination step calculates, during an elementary decoding step, a characteristic quantity from a set of weighted information items at the output of this elementary decoding step. For example, if reference is made to the turbo-decoding example described previously, the characteristic quantity calculation is performed from a set of values of the second output information, corresponding to a decoding sequence or a decoding sequence fraction. The decoded information quality parameter determination step determines, from the characteristic quantity and configuration parameters, a decoded information quality parameter associated with a set of decoded information items corresponding to the said set of weighted information items. Decoded information items means information items decoded by the elementary decoding step under consideration. This will be decoded information corresponding to the useful information if the elementary decoding step under consideration is the last step in the decoding procedure.

The present invention finds an application, for example, in a method of weighted combination of frames which were identical on sending but which have been transmitted and decoded differently, for example within a soft handover type method.

Figure 6 depicts schematically the basic principle of application of the present invention to a method of weighted combination of frames. This concerns a combination of transmission methods using a number of decoding procedures associated with one and the same coding procedure. A sequence coded by a turbo-code type coding procedure 60 is subjected to a repetition step with the result that this coded sequence is sent on n different channels 62. Channel means here a channel in the broad sense representing amongst other things the effect of puncturing, of modulation, of the physical channel itself, of demodulation and of detection. Each sequence, as modified by the corresponding channel, is subjected to a respective turbo-decoding type iterative decoding 63. There result therefrom n decoded sequences. The application of the present invention to each of the decoding procedures makes it possible to associate with each of these n sequences a respective weighting factor determined by the decoded information quality parameter determination step. A combination step 64 combines the n sequences by applying to each one its respective weighting factor, in order to obtain a final decoded sequence, representing the source information sequence. If the symbol αₖ is given to the weighting factor associated with a decoded sequence dₖ, with k=1...n, and if the symbol d is given to the sequence obtained by weighted combination, this gives: d=f(αₖ, dₖ)_{k=1...n}.

This application of the present invention is particularly advantageous in the mobile telephony field, for example when a mobile telephone is in communication with a number of base stations.

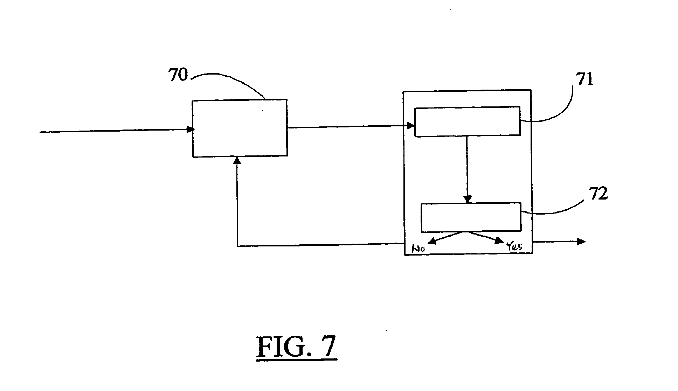

The present invention also finds an application, for example, in a transmission method comprising a joint detection step. Figure 7 depicts schematically the basic principle of application of the present invention to an iterative decoding method with a joint detection block. A joint detection block is a sub-optimal detection block of controllable efficiency and complexity. The corresponding joint detection step 70 receives, for example, sequences of weighted bits marred by ISI (Inter Symbol Interference) or MAI (Multiple Access Interference) and converts them into corresponding weighted bit sequences sent to a turbo-decoding type iterative decoding procedure 71. At the end of the decoding procedure, a decoded information quality parameter determination step generates a quality indicator corresponding to a decoded sequence. A switching step 72 compares the quality indicator with a predetermined threshold and, where the quality is not satisfactory, returns the sequence of weighted bits to the detection step 70 while commanding a new setting of the complexity and efficiency of the detection block according to the quality indicator.

## Claims

1. Digital transmission method of the error-correcting coding type based on coding and turbo decoding, in which the turbo decoding produces a decoded information quality parameter from a statistical quantity of a set of weighted output information and at least one configuration parameter,
**characterised in that**
said decode information quality parameter is a numerical scalar used as a weighting factor.

2. Digital transmission method of the error-correcting coding type, comprising, before a step of transmitting on a channel, a coding procedure for generating, from a source information item, a coded information item comprising at least one redundant information item and, after the said step of transmitting on the said channel, a decoding procedure for obtaining, from a received information item to be decoded (50), an estimate of the said source information item with correction of transmission errors based on the said at least one redundant information item, the said coding procedure comprising a plurality of elementary coding steps associated with a plurality of interleaving steps and acting in parallel or in series, the said decoding procedure being iterative and comprising, for each iteration, a plurality of elementary decoding steps (51, 52, 53; 83) which correspond to the said plurality of elementary coding steps with association with a plurality of adapted interleaving and deinterleaving steps, each of the said elementary decoding steps (51, 52, 53; 83) generating at least one weighted output information item which can be transmitted to one or more other elementary decoding steps, the said method being **characterised in that** it comprises a characteristic quantity determination step (54; 86) for calculating at least one characteristic quantity from a set of weighted output information items generated by at least one elementary decoding step (51, 52, 53; 83), and a decoded information quality parameter determination step (55; 85) for determining, from the said at least one characteristic quantity and at least one configuration parameter, a decoded information quality parameter associated with a set of decoded information items corresponding to the said set of weighted output information items.

3. Digital transmission method of the error-correcting coding type according to Claim 1 or 2, **characterised in that** the said decoded information quality parameter is used after the said decoding procedure.

4. Digital transmission method of the error-correcting coding type according to Claim 1 or 2, **characterised in that** the said decoded information quality parameter is used during the said decoding procedure.

5. Digital transmission method of the error-correcting coding type according to any one of the preceding claims, **characterised in that** each of the said elementary decoding steps uses part of the said received information, which corresponds to a redundant information item associated with the corresponding elementary coding step, for generating an output information item comprising an extrinsic information item which can be transmitted to one or more other elementary decoding steps, at least one extrinsic information item obtained during one iteration being transmitted to another iteration, and the said characteristic quantity determination step (86) calculating the said at least one characteristic quantity during an elementary decoding step (83) from a set of extrinsic information items at the output of the said elementary decoding step (83).

6. Digital transmission method of the error-correcting coding type according to any one of the preceding claims, **characterised in that** the said characteristic quantity is a statistical quantity.

7. Digital transmission method of the error-correcting coding type according to Claim 5,
**characterised in that** the said characteristic quantity is the mean of the absolute value of the extrinsic information calculated on the said set of extrinsic information items.

8. Digital transmission method of the error-correcting coding type according to Claim 5,
**characterised in that** the said characteristic quantity is a statistical quantity characterising the said set of extrinsic information items.

9. Digital transmission method of the error-correcting coding type according to any one of the preceding claims, **characterised in that** the said quality parameter determination step (55) determines the said decoded information quality parameter from a characteristic quantity calculated, by the said characteristic quantity determination step (54; 86) during an elementary decoding step (53) from a set of weighted output information items of the said elementary decoding step (53) and other characteristic quantities calculated during previous elementary decoding steps (51, 52) from sets of weighted output information items corresponding to the said set of weighted output information items of the said elementary decoding step (53), and at least one configuration parameter, the said decoded information quality parameter being associated with a set of decoded information items corresponding to the said set of weighted output information items of the said elementary decoding step (53).

10. Digital transmission method of the error-correcting coding type according to Claim 9,
**characterised in that** the said quality parameter determination step (55) determines the said quality parameter from characteristic quantities calculated during elementary decoding steps corresponding to the last elementary decoding steps (51, 52, 53) in the said decoding procedure.

11. Digital transmission method of the error-correcting coding type according to Claim 9,
**characterised in that** the said quality determination step (55) determines the said quality parameter from a single characteristic quantity calculated during the last elementary decoding step (53) in the said decoding procedure.

12. Digital transmission method of the error-correcting coding type according to any one of the preceding claims, **characterised in that** the said output information quality parameter is an integer number representing the probable number of errors which exist in the said set of decoded information items.

13. Digital transmission method of the error-correcting coding type according to any one of the preceding claims, **characterised in that** the said output information quality parameter is a scalar used as a weighting factor.

14. Digital transmission method of the error-correcting coding type according to any one of the preceding claims, **characterised in that** a configuration parameter is a parameter characterising the decoding conditions.

15. Digital transmission method of the error-correcting coding type according to any one of the preceding claims, **characterised in that** a configuration parameter is a parameter characterising the transmission conditions.

16. Digital transmission method of the error-correcting coding type according to any one of the preceding claims, **characterised in that** a configuration parameter is the signal to noise ratio.

17. Digital transmission method of the error-correcting coding type according to any one of the preceding claims, **characterised in that** the said information quality parameter determination step (55; 85) uses a predetermined algorithm allowing calculation of the said information quality parameter as a function of the said configuration parameters and one of more of the said characteristic quantities.

18. Digital transmission method of the error-correcting coding type according to any one of the preceding claims, **characterised in that** the said information quality parameter determination step (55; 85) uses a predetermined reference table to select an information quality parameter as a function of the said configuration parameters and one of more of the said characteristic quantities.

19. Digital transmission method of the error-correcting coding type according to any one of the preceding claims, **characterised in that**, the said received information (50) being processed by means of N-bit decoding sequences, the said set of decoded information items is a sequence of binary information items containing N symbols.

20. Digital transmission method of the error-correcting coding type according to any one of the preceding claims, **characterised in that**, the said received information (50) being processed by means of decoding sequences, the said set of decoded information items is a sequence of binary information items representing a fraction of a decoding sequence.

21. Digital transmission method of the error-correcting coding type according to any one of the preceding claims, **characterised in that** the said elementary decoding steps (51, 52, 53; 86) have inputs and outputs weighted in terms of probabilities, likelihood ratios, or log likelihood ratios.

22. Digital transmission method of the error-correct ing coding type according to any one of the preceding claims, **characterised in that** the said coding procedure comprises at least one puncturing step and the said decoding procedure comprises at least one corresponding de-puncturing step.

23. Digital transmission method of the error-correcting coding type according to any one of the preceding claims, **characterised in that**, in a combination of transmission methods using a number of decoding procedures (63) associated with one and the same coding procedure (60), decoded information quality parameters obtained respectively at the end of each of the decoding procedures form weighting factors for the corresponding sets of decoded information items with a view to a weighted combination (64) of these sets.

24. Digital transmission method of the error-correcting coding type according to any one of the preceding claims, **characterised in that**, in a transmission method comprising, furthermore, a joint detection step (70), the said decoded information quality parameter is used as a control parameter of the said joint detection step (70).
